# EUROPÄISCHE PATENTSCHRIFT

(11) **EP 2 429 273 B1**
(45) Veröffentlichungstag und Bekanntmachung des Hinweises auf die Patenterteilung: **24.04.2019**
(21) Anmeldenummer: 11176990.7
(22) Anmeldetag: 09.08.2011
(51) Int. Cl.: H05K 7/20, H01L 23/367, H01L 23/433

(54) **Kühlvorrichtung für ein elektrisches Gerät und zugehöriges Herstellungsverfahren**
Cooling device for an electric device and method for producing same
Dispositif de refroidissement pour un appareil électrique et procédé de fabrication associé

(30) Priorität: 13.09.2010 AT 15142010
(43) Veröffentlichungstag der Anmeldung: 14.03.2012
(73) Patentinhaber: MELECS EWS GmbH & Co KG, 7011 Siegendorf (AT)
(72) Erfinder: Hellinger, Leopold, 3710 Ziersdorf (AT); Neumann, Gerhard, 3231 St. Margarethen (AT); Vogt, Gerald, 2325 Himberg (AT)
(74) Vertreter: Maier, Daniel Oliver

(56) Entgegenhaltungen:
- EP-A1- 2 006 161
- DE-A1- 4 111 247
- DE-A1- 19 600 619
- DE-A1- 19 712 099
- JP-A- S63 226 952
- US-A- 5 808 868
- US-A1- 2003 227 750
- US-A1- 2009 261 472

## Beschreibung

### Technisches Gebiet

Die vorliegende Erfindung betrifft allgemein das Gebiet elektrischer Geräte, insbesondere Steuergeräte, und Gehäuse für diese. Im Speziellen bezieht sich die vorliegende Erfindung auf eine Kühlvorrichtung für ein elektrisches Gerät bzw. Steuergerät, welches in einem Gehäuse angeordnet ist. Das elektrische Gerät bzw. Steuergerät umfasst eine auf einer Trägerplatte angeordnete elektronische Schaltung umfasst, welche zumindest ein Verlustleistung produzierendes Element aufweist. Weiters bezieht sich die vorliebende Erfindung auch auf ein zugehöriges Verfahren zur Herstellung einer Kühlvorrichtung für ein elektrischen Gerät bzw. eine Steuervorrichtung.

### Stand der Technik

Elektrische Geräte, insbesondere Steuergeräte, sind üblicherweise elektronische Module, die überwiegend an Orten eingebaut werden, an welchen etwas gesteuert oder geregelt werden muss. Insbesondere in der Automobilindustrie werden elektrische Geräte bzw. Steuergeräte in vielen elektronischen Bereichen eingesetzt, wie z.B. zur Steuerung von Motoren und/oder Getriebe, für das Antiblockiersystem (ABS), für die elektronische Stabilisierungskontrolle, etc. Auch für diverse andere Funktionen wie z.B. Steuerung des Airbags, Tachometer, Drehzahlmessung, Tankstandsmessung und diverse andere Anzeigen werden im Kfz-Bereich Steuergeräte eingesetzt. Außerdem können Steuergeräte auch bei Maschinen, Anlagen und sonstigen technischen Prozessen in der Industrie zum Einsatz kommen.

Um ein elektrisches Gerät bzw. ein Steuergerät gegen Umwelteinflüsse oder mechanische Beanspruchung zu schützen, werden diese normalerweise in spezielle Gehäuse eingesetzt, welche beispielsweise teilweise aus Kunststoff und teilweise aus Aluminium hergestellt sein können. Dabei ist z.B. der untere Gehäuseteil mittels Spritzgussverfahren aus Kunststoff gefertigt. Das Gehäuse wird dann z.B. mit einem Deckel aus Aluminium verschlossen. Diese beiden Gehäuseteile können beispielsweise durch Schrauben, Nieten oder mittels Verkleben miteinander verbunden sein. Zwischen den beiden Gehäuseteilen ist üblicherweise eine Dichtung angebracht, welche meist aus Flüssig-Silikon hergestellt wird.

Das in dem Gehäuse angebrachte elektrische Gerät bzw. Steuergerät umfasst meist eine Trägerplatte, auf welcher eine elektronische Schaltung angeordnet ist. Diese Schaltung, von welcher die jeweilige Steuerung oder Regelung durchgeführt wird, ist üblicherweise aus Halbleiterbauelementen oder sogenannten Halbleiterchips - wie z.B. Mikrocontroller, Speicherbausteinen, etc. aufgebaut. Derartige Steuergeräte sind häufig mit einer sogenannten Eigenintelligenz versehen - d.h. sie bestehen aus einem eigenständigen Computer bzw. Prozessor in Form eines eingebetteten Systems. Je nach Aufgabe des elektrischen Geräts bzw. des Steuergeräts kann die Schaltung in ihrer Komplexität variieren.

Dabei weist die Schaltung des Steuergeräts häufig Halbleiterbauelemente auf, von welchen eine meist thermische Verlustleistung - d.h. Wärme - produziert wird. Um beispielsweise eine Beschädigung oder ein Überhitzen des elektrischen Geräts bzw. des Steuergeräts oder eine Störung seiner Funktion durch die Verlustleistung bzw. Wärmeproduktion dieser Halbleiterbauelemente zu verhindern, ist es notwendig, die Wärme entsprechend abzuleiten und für eine Kühlung des elektrischen Geräts zu sorgen.

Üblicherweise wird dazu die Trägerplatte, auf welcher sich die Verlustleistung produzierenden Halbleiterbauelemente befinden, mit Wärme ableitenden Teilen (z.B. Kühlkörper, Entwärmungsteil, etc.) verbunden. Ober diese zusätzlich angebrachten Teile wird dann die Wärme entsprechend - meist aus dem Gehäuse - ableitet. Von diesen Teilen wird daher eine sogenannte Wärmebrücke gebildet, um die entstandene Wärme aus dem Inneren des Gehäuses nach außen zu transportieren. Das Anbringen von Wärme ableitenden Teilen weist allerdings den Nachteil auf, dass bei Herstellung und Montage des elektrischen Geräts zusätzliche Aufwendung und Kosten entstehen. Denn die Wärme ableitenden Teile müssen beispielsweise in einem eigenen Arbeitsschritt z.B. mittels Nieten, Schrauben oder durch Aufkleben mit der Trägerplatte entsprechend angebracht werden, um einen Wärme leitenden Effekt zu erzielen.

Kühlvorrichtungen und Verfahren gemäß dem Stand der Technik werden in den Dokumenten US 5 808 868-A, DE 41 11 247-A1 und DE 197 12 099-A1 beschrieben.

### Darstellung der Erfindung

Der Erfindung liegt daher die Aufgabe zugrunde, eine Kühlvorrichtung für ein elektrisches Gerät sowie ein zugehöriges Herstellungsverfahren anzugeben, durch welche auf einfache und kostensparende Weise eine vom elektrischen Gerät produzierte Verlustleistung zielsicher abgeleitet wird. Die Lösung dieser Aufgabe erfolgt durch eine Kühlvorrichtung gemäß Anspruch 1 und ein Verfahren gemäß Anspruch 4.

Der Hauptaspekt der erfindungsgemäß vorgeschlagenen Lösung besteht darin, dass Anpress-Dome direkt über Verlustleistung produzierenden Elementen - üblicherweise Halbleiterelemente - der Trägerplatte gesetzt sind. Diese Anpress-Dome befinden sich vorzugsweise in einem ersten Gehäuseteil und sorgen - insbesondere durch einen Federwirkung - für eine mechanische und thermische Kontaktierung der Trägerplatte mit einem Kühlelement wie z.B. einem zweiten Gehäuseteil (z.B. Gehäusedeckel aus Aluminium). Dadurch wird auf einfache und zuverlässige Weise die Verlustwärme der Elemente über die Trägerplatte und das Kühlelement abtransportiert. Schäden durch z.B. Überhitzung, etc. des elektrischen Geräts werden somit verhindert.

Es ist vorteilhaft, wenn der Anpress-Dom wie eine Dichtung für das Gehäuse aus Flüssig-Silikon hergestellt ist, da dann der zumindest eine Anpress-Dom im selben Arbeitsschritt wie die Dichtung herstellbar und im entsprechenden Gehäuseteil anbringbar ist. Auf diese Weise können bei der Herstellung und Montage des elektrischen Geräts mit Gehäuse Kosten eingespart werden, da kein eigener Arbeitsschritt für ein Anbringen von Wärme ableitenden Teilen mehr notwendig ist.

Es ist günstig, wenn nach einem Montageschritt der Anspress-Dom mit einer Andrückkraft von 100 bis 200 Newton auf das zumindest eine Verlustleistung produzierende Element gepresst ist. Idealerweise ist dabei - nach dem Montageschritt - der Anpress-Dom auf Dreiviertel seiner unbelasteten Höhe zusammengepresst. Durch die Andrückkraft bzw. das Zusammenpressen des Anpress-Doms wird eine Federwirkung erzielt und dadurch eine sichere mechanische sowie thermische Kontaktierung der Trägerplatte mit z.B. einem Kühlelement oder einem Wärme ableitenden Gehäuseteil (z.B. Gehäusedeckel) erreicht. Die Anpress-Dome sind dabei z.B. in einem ersten bzw. unteren Gehäuseteil so angeordnet, dass diese auf die Verlustleistung produzierendes Elementen gepresst sind. Die z.B. nach dem Schließen des Gehäuses entstehende Andrückkraft sorgt dann dafür, dass die Element bzw. die Trägerplatte entsprechend gegen den Wärme ableitenden Teil - beispielsweise den Gehäusedeckel - gepresst sind. Die entstehende Verlustwärme wird dadurch sicher aus dem Gehäuseinneren ab- bzw. vom elektrischen Gerät weggeleitet.

Die Lösung der genannten Aufgabe erfolgt auch durch ein Verfahren zur Herstellung der erfindungsgemäßen Kühlvorrichtung für ein elektrisches Gerät, wobei bei einer auf einer Trägerplatte angeordneten elektronischen Schaltung mit zumindest einem Verlustleistung produzierenden Element über diesem Element ein Anpress-Dom derart angebracht wird und dann in einem Montageschritt der Anpress-Dom derart gepresst wird, dass für die Trägerplatte eine thermische und mechanische Kontaktierung z.B. mit einem Kühlelement garantiert wird.

Der Hauptaspekt des erfindungsgemäßen Verfahrens besteht darin, dass durch ein Herstellen von einem mechanischen und thermischen Kontakt zwischen der Trägerplatte und einem Kühlelement (z.B. Gehäusedeckel, etc.) - insbesondere in den Bereichen, in denen Verlustleistung produzierende Elemente angebracht sind - die Verlustwärme auf sichere und einfache Weise abgeleitet wird. Damit werden Beschädigungen des elektrischen Geräts durch Wärme verhindert. Der Einsatz von Anpress-Domen weist zusätzlich den Vorteil der Kostenersparnis auf, da jener Arbeitsgang entfallen kann, bei welchen beispielsweise Wärme ableitende Teile auf die Trägerplatte geschraubt, genietet oder geklebt werden.

Der Anpress-Dom wird vorteilhaft aus Flüssig-Silikon hergestellt, welches in einem ersten Gehäuseteil auf einfache Weise angebracht werden kann. Dabei ist es günstig, wenn dazu ein sogenanntes Spritzgussverfahren eingesetzt wird. Auf diese Weise können die notwendigen Anpress-Dome gemeinsam mit der Dichtung für das Gehäuse in einem Arbeitsgang z.B. in einem ersten Gehäuseteil aufgebracht werden, bevor das elektrische Gerät im Gehäuse angeordnet wird. Dem Spritzgussverfahren werden Positionen und Anzahl für die Anpress-Dome vorgegeben, damit diese genau über den Verlustleistung produzierenden Elementen des elektrischen Geräts positioniert sind.

Idealerweise wird beim Montageschritt der Anpress-Dom mit einer Andrückkraft von 100 bis 200 Newton auf das Verlustleistung produzierende Element und damit auf die Trägerplatte gepresst. Dabei wird der Anpress-Dom auf Dreiviertel bzw. zirka 75% seiner unbelasteten Höhe zusammengepresst und wie eine Feder gespannt. Von einer dabei entstehenden Andrücckraft wird dann für eine sichere mechanische und thermische Kontaktierung der Trägerplatte mit einem Kühlelement oder einem Verlustwärme ableitenden Gehäusedeckel gesorgt. Diese sichere Kontaktierung wird beispielsweise durch ein Zusammenfügen der Gehäuseteile beim Montageschritt erzielt. Damit kann ein eigener Verbindungsarbeitsgang, bei welchen z.B. die Trägerplatte mit Kühlelementen durch Anschrauben oder Aufkleben verbunden wird, entfallen.

In einer weiteren Optimierung des erfindungsgemäßen Verfahrens wird beim Spritzgussverfahren zuerst in einem ersten Schritt ein erster Gehäuseteil für das elektrische Gerät aus Thermoplast erzeugt. In einem zweiten Schritt wird dann der zumindest eine Anpress-Dom sowie die Dichtung für das Gehäuse aus Flüssig-Silikon aufgebracht. In einem weiteren Schritt - dem Montageschritt - kann dann nach Einfügen des elektrischen Geräts bzw. des Steuergeräts auf einfache Weise der zweite Gehäuseteil (z.B. Gehäusedeckel) angebracht und mit dem ersten Gehäuseteil z.B. mittels Schrauben verbunden werden. Durch das Schließen des Gehäuses wird der zumindest eine Anpress-Dom auf das zumindest eine Verlustleistung produzierende Element gepresst. Durch die dabei entstehende Andrückkraft wird auf einfache und kostengünstige Weise für einen mechanische und thermische Kontaktierung der Trägerplatte mit z.B. dem zweiten Gehäuseteil bzw. dem Gehäusedeckel gesorgt und über diesen die Wärme auf sichere und einfache Weise aus dem Gehäuse geleitet. Der Anpress-Dom bzw. die Anpress-Dome weisen dabei eine Wirkung wie einen Feder auf.

### Kurzbeschreibung der Zeichnung

Die Erfindung wird nachfolgend in beispielhafter Weise anhand der beigefügten Figuren erläutert. Es zeigen:
Figur 1 beispielhaft einen schematischen Aufbau der erfindungsgemäßen Kühlvorrichtung für ein elektrisches Gerät in einem Gehäuse
Figur 2a, 2b und 2c beispielhaft und schematisch Anbringung und Montage der erfindungsgemäßen Kühlvorrichtung für eine elektrisches Gerät in einem Gehäuse

### Ausführung der Erfindung

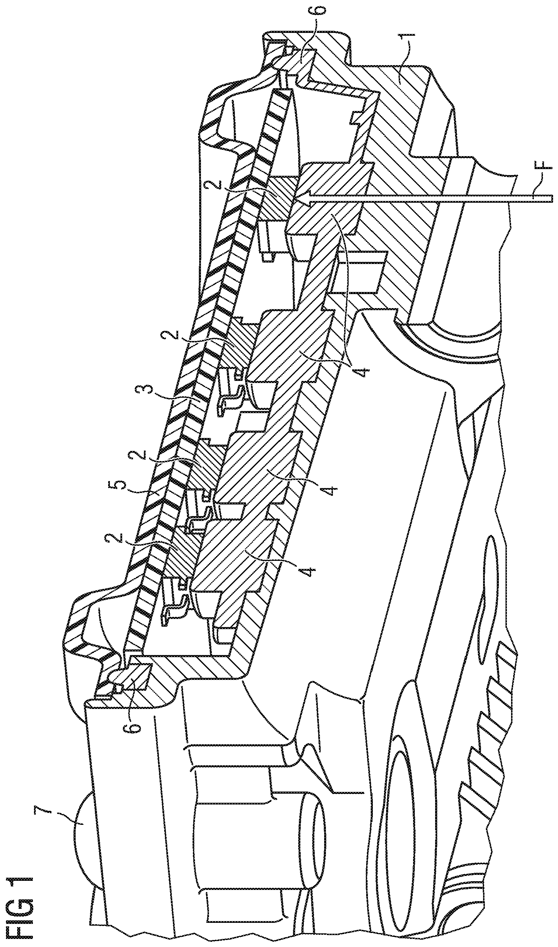

In der Figur 1 ist schematisch und beispielhaft ein Schnitt durch ein elektronisches Gerät, beispielsweise ein Steuergerät für den Kfz-Bereich, dargestellt, welches sich in einem Gehäuse befindet und eine erfindungsgemäße Kühlvorrichtung aufweist.

Das Gehäuse des Steuergeräts besteht aus zwei Gehäuseteilen 1 und 5. Ein erster bzw. unterer Gehäuseteil 1 ist beispielsweise aus Thermoplast ausgeführt. Ein zweiter Gehäuseteil 5 bzw. Gehäusedeckel 5 ist beispielsweise aus Metall wie z.B. Aluminium hergestellt und kann daher auch für einen Ableitung von Wärme bzw. als Kühlkörper eingesetzt werden. Zwischen den beiden Gehäuseteilen 1 und 5 ist eine Dichtung 6 angebracht, die üblicherweise mittels Spritzgussverfahren aus Flüssig-Silikon hergestellt ist. Die beiden Gehäuseteile 1 und 5 sind mittels Verbindungselemente 7 wie z.B. Schrauben, Nieten, etc. miteinander verbunden.

Im Gehäuseinneren ist das elektrische Gerät angebracht, welches eine Trägerplatte 3 umfasst. Auf der Trägerplatte 3 ist eine elektronische Schaltung angeordnet, von welcher das eigentliche elektrische Gerät bzw. Steuergerät gebildet wird. Die elektronische Schaltung ist aus elektronischen Bauelementen 2 - meist sogenannten Halbleiterbauelementen aufgebaut. Von diesen Halbleiterbauelementen wird üblicherweise während des Betriebs des elektrischen Geräts eine Verlustleistung - meist in Form von Wärme - produziert.

Direkt bei den Verlustleistung produzierenden elektrischen Bauelementen 2 sind im ersten bzw. unteren Gehäuseteil 1 Anpress-Dome 4 derart angebracht, dass nach Einfügen des elektrischen Geräts bzw. der Trägerplatte 3 mit der elektrischen Schaltung die Verlustleistung produzierenden elektrischen Bauelemente 2 auf den Anpress-Domen 4 zum Liegen kommen. Aus Sicht der Trägerplatte 3 bzw. der elektrischen Schaltung befinden sich die Anpress-Dome 4 damit über den Verlustleistung produzierenden Bauelementen 2. Die Anpress-Dome 4 sind - wie die Dichtung 6 - mittels Spritzgussverfahren aus Flüssig-Silikon hergestellt.

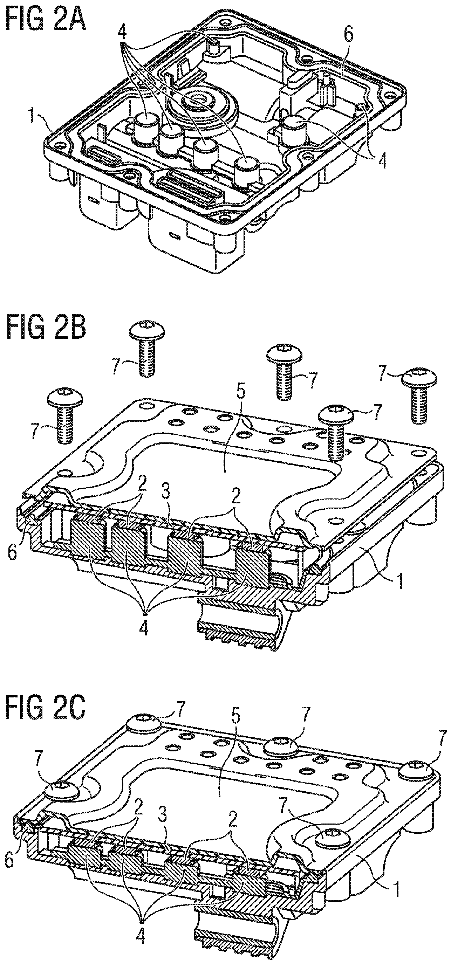

Nach Verschließen des Gehäuses z.B. mittels Schrauben 7 üben die Anpress-Dome 4 eine Art Federwirkung aus, welche in den folgenden Figuren 2b und 2c noch näher erläutert wird. Es wirkt dann einen Andrückkraft F von den Anpress-Domen 4 auf die elektrischen Bauelement 2 und damit auf die Trägerplatte 3. Dadurch wird eine sichere mechanische und thermische Kontaktierung der Trägerplatte 3 mit dem zweiten Gehäuseteil 5 bzw. dem Gehäusedeckel 5 erreicht. Durch diese Kontaktierung wirkt der Gehäusedeckel 5 als Kühlkörper und die Verlustwärme, welche von den elektronischen Bauelementen 2 produziert wird, wird aus dem Gehäuseinneren ab- bzw. vom elektrischen Gerät weggeleitet.

Figur 2a zeigt beispielhaft und schematisch den ersten bzw. unteren Gehäuseteil 1 vor dem Einfügen des elektrischen Geräts bzw. der Trägerplatte 3 mit der elektrischen Schaltung. Der untere Gehäuseteil 1 wird beispielsweise mittels eines sogenannten 2K-Spritzgussverfahren oder 2-Shoot Molding-Verfahren hergestellt. Dabei wird in einem ersten Schritt - einem sogenannten ersten Schuss - mittels Spritzguss der untere Gehäuseteil 1 aus einem Thermoplast (Kunststoff) hergestellt. Nach Erstarren des unteren Gehäuseteils 1 wird in einem zweiten Schritt bzw. zweiten Schuss die Dichtung 6 sowie die für die Verlustleistung produzierenden Bauelemente notwendigen Anpress-Dome 4 aus Flüssig-Silikon in Form eines separaten Spritzaggregats angespritzt.

Nach Abschluss des Spritzgussverfahrens kann in einem weiteren Arbeitsschritt das elektrische Gerät - d.h. die Trägerplatte 3 mit der elektrischen Schaltung - in den unteren Gehäuseteil 1 eingefügt werden. Dabei wird dann aus Sicht der Trägerplatte 3 über jedem Verlustleistung produzierenden Bauelement 2 jeweils ein Anpress-Dom 4 aus Flüssig-Silikon angebracht - d.h. jedes Verlustleistung produzierende Bauelement 2 kommt auf einem Anpress-Dom 4 zum Liegen, von welchem eine mechanische und thermische Kontaktierung der Trägerplatte 3 mit einem Kühlkörper wie z.B. dem Gehäusedeckel 5 garantiert wird.

In den Figuren 2b und 2c ist in beispielhafter und schematischer Weise einen Montage der erfindungsgemäßen Kühlvorrichtung dargestellt.

Figur 2b zeigt dabei anhand eines Schnitts durch das elektrische Gerät mit Gehäuse einen ersten Teil eines Montageschritts. Nachdem die Trägerplatte 3 mit der elektrischen Schaltung bzw. mit den Verlustleistung produzierenden Bauelementen 2 in den ersten Gehäuseteil 1 eingefügt worden ist, sind die Anpress-Dome 4, welche aus Flüssig-Silikon mittels des Spritzgussverfahrens im ersten Gehäuseteil 1 angebracht worden sind, derart gelegen, dass die Verlustleistung produzierenden Bauelemente 2 von den Anpress-Domen 4 bedeckt werden. D.h. aus Sicht der Trägerplatte 3 befindet sich über jedem Verlustleistung produzierenden Bauelement 2 ein Anpress-Dom 4. Über der Trägerplatte 3 mit den Bauelementen 2 wird dann der zweite Gehäuseteil 5 bzw. der Gehäusedeckel 5 angebracht, welcher beispielsweise aus Aluminium hergestellt ist. Für den Verschluss des Gehäuses werden beim ersten Teil des Montageschritts in beiden Gehäuseteilen 1 und 5 in dafür vorgesehenen Öffnungen Verschlusselemente 7 wie z.B. Schrauben eingefügt. Für eine Abdichtung des Gehäuses ist üblicherweise die Dichtung 6, welche ebenfalls aus Flüssig-Silikon hergestellt sein kann, vorgesehen.

Figur 2c zeigt in schematischer Weise beispielhaft eine zweiten Teil des Montageschritts. Beim zweiten Teil wird der Gehäusedeckel 5 durch die Verschlusselemente 7 am ersten Gehäuseteil 1 befestigt und das Gehäuse geschlossen. Dies kann beispielsweise durch Festziehen der Schrauben 7 erfolgen. Beim Verschließen des Gehäuses werden die Anpress-Dome 4 zusammengepresst - auf zirka Dreiviertel bzw. 75% ihrer unbelasteten Höhe. Dadurch entsteht einen Federwirkung, durch welche von den Anpress-Dome mit einer Andrückkraft F von 100 bis 200 Newton auf die Bauelemente 2 und damit auf die Trägerplatte 3 gepresst wird. Durch die Andrückkraft F wird dann von der Trägerplatte 3 - insbesondere in den Bereichen der Verlustleistung produzierenden Bauelemente 2 - der Gehäusedeckel 5 mechanisch und thermisch kontaktiert.

Dadurch wird auf einfache und sichere Weise die Verlustleistung bzw. die Verlustwärme aus dem Gehäuse abtransportiert und damit eine Beschädigung des elektrischen Geräts verhindert. Durch den Einsatz der Anpress-Dome 4 aus Flüssig-Silikon kann außerdem ein Arbeitsschritt, bei welchem eigene Wärme ableitende Teile an der Trägeplatte 3 z.B. durch Nieten, Schrauben oder Kleben angebracht werden, entfallen, wodurch zusätzlich Kosten bei der Produktion des elektrischen Geräts mit Gehäuse gespart werden können.

### Bezugszeichenliste

- 1: Erster Gehäuseteil
- 2: Elektrisches Bauelement
- 3: Trägerplatte
- 4: Anpress-Dom
- 5: Zweiter Gehäuseteil (Gehäusedeckel)
- 6: Dichtung
- 7: Verschlusselemente

## Patentansprüche

1. Kühlvorrichtung für ein elektrisches Gerät, insbesondere Steuergerät, welches in einem Gehäuse (1, 5) mit einer Dichtung (6) angeordnet ist, und eine auf einer Trägerplatte (3) angeordnete elektronische Schaltung umfasst, welche zumindest ein Verlustleistung produzierendes Element (2) aufweist, wobei über dem zumindest einen Verlustleistung produzierenden Element (2) ein Anpress-Dom (4) derart angeordnet ist, dass eine mechanische und thermische Kontaktierung zur Trägerplatte (3) garantiert ist, **dadurch gekennzeichnet, dass** der Anpress-Dom (4) wie die Dichtung (6) für das Gehäuse (1, 5) aus Flüssig-Silikon hergestellt ist.

2. Kühlvorrichtung nach Anspruch 1, **dadurch gekennzeichnet, dass** nach einem Montageschritt der Anpress-Dom (4) mit einer Andrückkraft (F) von 100 bis 200 Newton angepresst ist.

3. Kühlvorrichtung nach einem der vorangegangenen Ansprüche, **dadurch gekennzeichnet, dass** nach einem Montageschritt der Anpress-Dom (4) auf Dreiviertel seiner unbelasteten Höhe gepresst ist.

4. Verfahren zur Herstellung einer Kühlvorrichtung für ein elektrisches Gerät nach einem der Ansprüchen 1 bis 3, **dadurch gekennzeichnet, dass** bei einer auf einer Trägerplatte (3) angeordneten elektronischen Schaltung mit zumindest einem Verlustleistung produzierenden Element (2) über diesem Element (2) ein Anpress-Dom (4) derart angebracht wird, und dann in einem Montageschritt der Anpress-Dom (4) derart angepresst wird, dass für die Trägerplatte (3) eine thermische und mechanische Kontaktierung garantiert wird, und dass der Anpress-Dom (4) mittels Spritzgussverfahren aufgebracht wird.

5. Verfahren nach Anspruch 4, **dadurch gekennzeichnet, dass** bei einem Montageschritt der Anpress-Dom (4) mit einer Andrückkraft (F) von 100 bis 200 Newton angepresst wird.

6. Verfahren nach Anspruch 4, **dadurch gekennzeichnet, dass** beim Montageschritt der Anpress-Dom (4) auf Dreiviertel seiner unbelasteten Höhe gepresst wird.

7. Verfahren nach einem der Ansprüche 4 bis 6, **dadurch gekennzeichnet, dass** beim Spritzgussverfahren zuerst in einem ersten Schritt ein erster Gehäuseteil (1) für das elektrische Gerät aus Thermoplast erzeugt wird, und dass dann in einem zweiten Schritt der zumindest eine Anpress-Dom (4) sowie eine Dichtung (6) für das Gehäuse (1, 5) aus Flüssig-Silikon auf den ersten Gehäuseteil (1) aufgebracht wird.

## Claims

1. Cooling apparatus for an electrical device, in particular control device, which is arranged in a housing (1, 5) with a seal (6), and comprises an electronic circuit arranged on a support plate (3), which has at least one element (2) producing a power loss, wherein a press-on dome (4) is arranged over the at least one element (2) producing a power loss such that a mechanical and thermal contact with the support plate (3) is guaranteed, **characterised in that** the press-on dome (4), as with the seal (6) for the housing (1, 5), is manufactured from liquid silicone.

2. Cooling apparatus according to claim 1,
**characterised in that** according to one assembly step the press-on dome (4) is pressed on with a compressive force (F) of 100 to 200 Newtons.

3. Cooling apparatus according to one of the preceding claims, **characterised in that** according to one assembly step the press-on dome (4) is pressed to three quarters of its unstressed height.

4. Method for manufacturing a cooling apparatus for an electrical device according to one of claims 1 to 3, **characterised in that** in the case of an electronic circuit arranged on a support plate (3) with at least one element (2) producing a power loss, a press-on dome (4) is attached via said element (2) such that, and then in an assembly step the press-on dome (4) is pressed on such that a thermal and mechanical contact is guaranteed for the support plate (3), and that the press-on dome (4) is applied by means of an injection moulding method.

5. Method according to claim 4, **characterised in that** in one assembly step the press-on dome (4) is pressed on with a compressive force (F) of 100 to 200 Newtons.

6. Method according to claim 4, **characterised in that** in the assembly step the press-on dome (4) is pressed to three quarters of its unstressed height.

7. Method according to one of claims 4 to 6,
**characterised in that** during the injection moulding method, in a first step a first housing part (1) for the electrical device is firstly generated from a thermoplastic, and that in a second step the at least one press-on dome (4) and also a seal (6) for the housing (1, 5) made of liquid silicone are then applied to the first housing part (1).

## Revendications

1. Dispositif de refroidissement pour un appareil électrique, notamment appareil de commande, lequel est disposé dans un boîtier (1, 5) avec un joint (6) et comprend un circuit électronique disposé sur une plaque de support (3) qui présente au moins un élément (2) produisant une perte de puissance, un dôme de pressage (4) étant disposé sur l'au moins un élément (2) produisant une perte de puissance de manière à ce qu'une mise en contact mécanique et thermique vers la plaque de support (3) soit garantie, **caractérisé en ce que** le dôme de pressage (4), comme le joint (6) pour le boîtier (1, 5), est fabriqué en silicone liquide.

2. Dispositif de refroidissement selon la revendication 1, **caractérisé en ce qu'**après une étape de montage, le dôme de pressage (4) est pressé avec une force de pression (F) de 100 à 200 newtons.

3. Dispositif de refroidissement selon l'une quelconque des revendications précédentes, **caractérisé en ce qu'**après une étape de montage, le dôme de pressage (4) est pressé sur trois quarts de sa hauteur non chargée.

4. Procédé de fabrication d'un dispositif de refroidissement pour un appareil électrique selon l'une quelconque des revendications 1 à 3, **caractérisé en ce qu'**avec un circuit électronique disposé sur une plaque de support (3) doté d'un élément (2) produisant au moins une perte de puissance, un dôme de pressage (4) est placé au-dessus de cet élément (2) et qu'ensuite, dans une étape de montage, le dôme de pressage (4) est pressé de manière à ce qu'une mise en contact thermique et mécanique soit garantie pour la plaque de support (3), et **en ce que** le dôme de pressage (4) est appliqué au moyen d'un procédé de moulage par injection.

5. Procédé selon la revendication 4, **caractérisé en ce que** lors d'une étape de montage, le dôme de pressage (4) est pressé avec une force de pression (F) de 100 à 200 newtons.

6. Procédé selon la revendication 4, **caractérisé en ce que** lors d'une étape de montage, le dôme de pressage (4) est pressé sur trois quarts de sa hauteur non chargée.

7. Procédé selon l'une quelconque des revendications 4 à 6, **caractérisé en ce que** lors du procédé de moulage par injection, d'abord dans une première étape, une première partie de boîtier (1) est générée en thermoplastique pour l'appareil électrique et qu'ensuite, dans une deuxième étape, l'au moins un dôme de pressage (4) ainsi qu'un joint (6) pour le boîtier (1, 5) sont appliqués, en silicone liquide, sur la première partie de boîtier (1).
